(19) Europäisches Patentamt
European Patent Office
Office européen des brevets

(11) **EP 4 079 510 A1**

(12) **EUROPEAN PATENT APPLICATION**

(43) Date of publication:
**26.10.2022   Bulletin 2022/43**

(21) Application number: **22168563.9**

(22) Date of filing: **14.04.2022**

(51) International Patent Classification (IPC):
**B32B 5/20** (2006.01)    **B32B 7/12** (2006.01)
**B32B 15/04** (2006.01)    **B32B 15/20** (2006.01)
**C08G 73/10** (2006.01)    **H05K 1/03** (2006.01)

(52) Cooperative Patent Classification (CPC):
**B32B 5/20; B32B 7/12; B32B 15/046; B32B 15/20;
C08G 73/10; H05K 1/036;** B32B 2250/40;
B32B 2255/06; B32B 2255/26; B32B 2255/28;
B32B 2266/0214; B32B 2266/08; B32B 2270/00;
B32B 2307/204; B32B 2307/54;         (Cont.)

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority:  **19.04.2021   JP 2021070655**

(71) Applicant: **Nitto Denko Corporation
Ibaraki-shi
Osaka 567-8680 (JP)**

(72) Inventors:
• **SAWASHI, Kanayo
Osaka, 567-8680 (JP)**
• **MATSUTOMI, Akihito
Osaka, 567-8680 (JP)**
• **HODONO, Masayuki
Osaka, 567-8680 (JP)**

(74) Representative: **Gill Jennings & Every LLP
The Broadgate Tower
20 Primrose Street
London EC2A 2ES (GB)**

(54)     **FILM FOR METAL LAYER LAMINATE BOARD AND METAL LAYER LAMINATE BOARD**

(57)     [Problem]
To provide a film for a metal layer laminate board and a metal layer laminate board having excellent stiffness, while capable of suppressing fluctuation of a dielectric constant before and after pressing.

[Solving Means]
A film 1 for a metal layer laminate board includes a porous resin layer 2 having a tensile elastic modulus at 25°C of 800 MPa or more and 2000 MPa or less.

FIG. 1

(52) Cooperative Patent Classification (CPC): (Cont.)
B32B 2457/00; B32B 2457/08

**Description**

TECHNICAL FIELD

The present invention relates to a film for a metal layer laminate board and a metal layer laminate board.

BACKGROUND ART

A film for a metal layer laminate board including a porous resin layer has been known (ref: for example, Patent Document 1 below). The film for a metal layer laminate board of Example of Patent Document 1 includes a porous polyimide film which is a reaction product of a diamine component containing a p-phenylenediamine and an oxydianiline and an acid dianhydride component as a porous resin layer. A metal layer laminate board is produced from the film for a metal layer laminate board.

Citation List

Patent Document

Patent Document 1: WO2018/186486

SUMMARY OF THE INVENTION

PROBLEM TO BE SOLVED BY THE INVENTION

When the metal layer laminate board is produced, the film for a metal layer laminate board may be pressed (specifically, thermally pressed) in a thickness direction. Furthermore, when the metal layer laminate board is processed, the film for a metal layer laminate board may be pressed (specifically, thermally pressed) in the thickness direction. In those cases, in a substrate for metal layer lamination of Patent Document 1, a reduction rate of a thickness thereof after pressing becomes excessive. Then, there is a problem that a dielectric constant after pressing greatly increases.

Also, the metal layer laminate board may be bent and disposed in a narrow space. However, the metal layer laminate board of Patent Document 1 has excessive stiffness. Therefore, there is a problem that it is difficult to bend the metal layer laminate board by applying a load thereto. The stiffness is a stress of the metal layer laminate board which is bent based on the load, and a low value of the stiffness means excellent in the stiffness.

The present invention provides a film for a metal layer laminate board and a metal layer laminate board having excellent stiffness, while capable of suppressing a reduction rate of a thickness after pressing.

MEANS FOR SOLVING THE PROBLEM

The present invention (1) includes a film for a metal layer laminate board including a porous resin layer having a tensile elastic modulus at 25°C of 800 MPa or more and 2000 MPa or less.

The present invention (2) includes the film for a metal layer laminate board described in (1) further including an adhesive layer disposed on one surface in a thickness direction of the porous resin layer.

The present invention (3) includes a metal layer laminate board including the film for a metal layer laminate board described in (1) or (2), and a metal layer disposed on one surface in a thickness direction of the film for a metal layer laminate board.

EFFECT OF THE INVENTION

The film for a metal layer laminate board and the metal layer laminate board of the present invention have excellent stiffness, while capable of suppressing fluctuation of a dielectric constant before and after pressing.

BRIEF DESCRIPTION OF THE DRAWINGS

FIG. 1 shows a cross-sectional view of one embodiment of a film for a metal layer laminate board of the present invention.
FIG. 2 shows a cross-sectional view of a modified example of a metal layer laminate board.

FIG. 3 shows a cross-sectional view of a modified example of a film for a metal layer laminate board.
FIG. 4 shows a cross-sectional view of a modified example of a film for a metal layer laminate board.
FIG. 5 shows a cross-sectional view for illustrating evaluation of stiffness in Examples.

## DESCRIPTION OF EMBODIMENTS

<Film for Metal Layer Laminate Board>

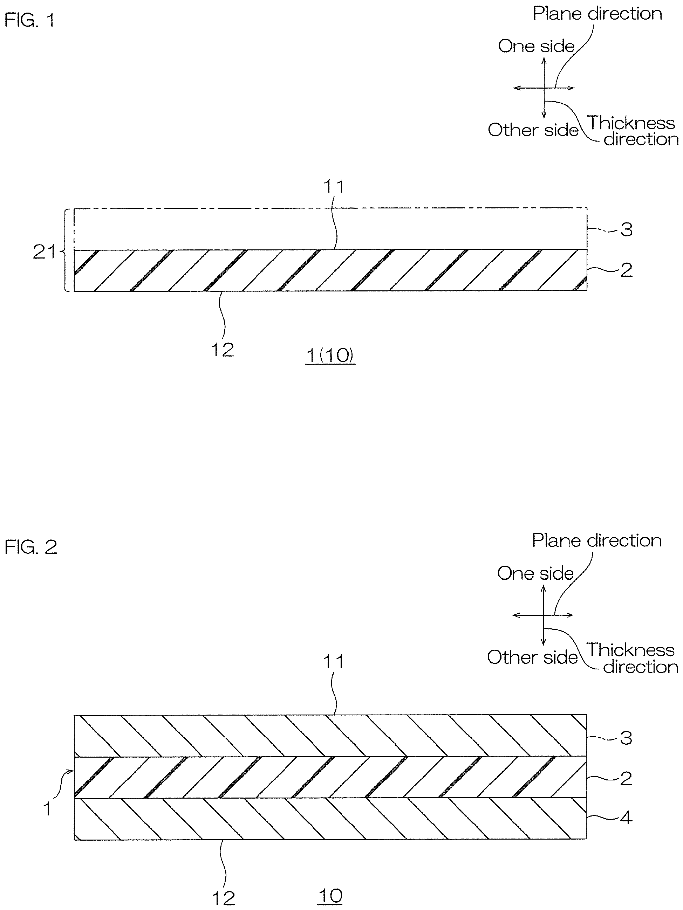

One embodiment of a film for a metal layer laminate board of the present invention is described with reference to FIG. 1. A film 1 for a metal layer laminate board has a thickness. The film 1 for a metal layer laminate board has a one surface 11 and an other surface 12 facing each other in a thickness direction. The one surface 11 faces one side in the thickness direction. The other surface 12 faces the other side in the thickness direction. A thickness of the film 1 for a metal layer laminate board is not particularly limited. The film 1 for a metal layer laminate board extends in a plane direction perpendicular to the thickness direction.

The film 1 for a metal layer laminate board includes a porous resin layer 2. In this embodiment, the film 1 for a metal layer laminate board includes only the porous resin layer 2. The one surface 11 and the other surface 12 of the porous resin layer 2 are the same as the one surface 11 and the other surface 12 of the film 1 for a metal layer laminate board 1, respectively.

<Tensile Elastic Modulus of Porous Resin Layer 2>

The porous resin layer 2 has a tensile elastic modulus at 25°C of 800 MPa or more and 2000 MPa or less.
When the tensile elastic modulus at 25°C of the porous resin layer 2 is below the above-described lower limit, a reduction rate of a thickness of the film 1 for a metal layer laminate board after pressing becomes large. Then, a dielectric constant after pressing greatly increases.
When the tensile elastic modulus at 25°C of the porous resin layer 2 is above the above-described upper limit, stiffness of the film 1 for a metal layer laminate board decreases.
The porous resin layer 2 has a tensile elastic modulus at 25°C of preferably 900 MPa or more, more preferably 950 MPa or more. Also, the porous resin layer 2 has a tensile elastic modulus at 25°C of preferably 1600 MPa or less, more preferably 1500 MPa or less, further more preferably 1300 MPa or less, particularly preferably 1100 MPa or less.
The tensile elastic modulus of the porous resin layer 2 is determined as an initial inclination in a stress-strain curve obtained when the porous resin layer 2 is subjected to a tensile test at 25°C at a rate of 5 mm/min.
The porous resin layer 2 is porous. The porous resin layer 2 has a closed cell structure and/or an open cell structure. The porous resin layer 2 has a porosity of, for example, 50% or more, preferably 60% or more, more preferably 70% or more. The porous resin layer 2 also has a porosity of, for example, below 100%, furthermore 99% or less. When the porous resin layer 2 is made of a polyimide resin, the porosity is determined from the following formula.

$$\text{Dielectric constant of the porous resin layer 2} = \text{dielectric constant of air} \times \text{porosity} + \text{dielectric constant of polyimide resin} \times (1 - \text{porosity})$$

The porous resin layer 2 has a thickness of, for example, 2 $\mu$m or more, preferably 5 $\mu$m or more, and for example, 1000 $\mu$m or less, preferably 500 $\mu$m or less.

<Material for Porous Resin Layer 2>

A material for the porous resin layer 2 is a resin. The resin is not limited. Specific examples of the resin include polycarbonate resins, polyimide resins, fluoride polyimide resins, epoxy resins, phenol resins, urea resins, melamine resins, diallyl phthalate resins, silicone resins, thermosetting urethane resins, fluororesins (polymers of fluorine-containing olefin (specifically, polytetrafluoroethylenes (PTFE)), and liquid crystal polymers (LCP). These may be used alone or in combination of two or more. Of the above-described resins, from the viewpoint of mechanical strength, preferably, a polyimide resin is used. Details including properties and a producing method of the polyimide resin are, for example, described in WO2018/186486 and Japanese Unexamined Patent Publication No. 2020-172667. The polyimide resin may be simply referred to as a polyimide.

<Properties of Film 1 for Metal Layer Laminate Board>

The film 1 for a metal layer laminate board has a dielectric constant at a frequency of 10 GHz of, for example, 2.5 or less, preferably 2.0 or less, more preferably 1.9 or less, further more preferably 1.8 or less, particularly preferably 1.7 or less, most preferably 1.6 or less, and for example, above 1.0. The dielectric constant of the film 1 for a metal layer laminate board is measured by a resonant method. Also, as in a modified example to be described later, when the film 1 for a metal layer laminate board includes a layer other than the porous resin layer 2, the dielectric constant of the film 1 for a metal layer laminate board may be different from that of the porous resin layer 2.

In this embodiment, the tensile elastic modulus of the film 1 for a metal layer laminate board at 25°C is the same as that of the porous resin layer 2 at 25°C. Also, as in the modified example to be described later, when the film 1 for a metal layer laminate board includes a layer other than the porous resin layer 2, the tensile elastic modulus of the film 1 for a metal layer laminate board may be different from that of the porous resin layer 2. In that case, the film 1 for a metal layer laminate board has a tensile elastic modulus at 25°C of, for example, 500 MPa or more, preferably 600 MPa or more, more preferably 700 MPa or more, further more preferably 770 MPa or more, particularly preferably 840 MPa or more, and 2000 MPa or less. A method for measuring the tensile elastic modulus of the film 1 for a metal layer laminate board is the same as that of the porous resin layer 2.

<Method for Producing Film 1 for Metal Layer Laminate Board>

Next, a method for producing the film 1 for a metal layer laminate board is described.

Specifically, first, a metal layer 3 (phantom line) is prepared. The metal layer 3 is a metal film extending in the plane direction. Examples of a metal include copper, iron, silver, gold, aluminum, nickel, and alloys of these (stainless steel and bronze). As the metal, preferably, copper is used. The metal layer 3 has a thickness of, for example, 0.1 $\mu$m or more, preferably 1 $\mu$m or more, and for example, 100 $\mu$m or less, preferably 50 $\mu$m or less.

Next, a varnish containing a precursor of the above-described resin, a porosity forming agent, a nucleating agent, and a solvent is prepared, and then, the varnish is applied to one surface in the thickness direction of the metal layer 3 to form a coating film. A kind, a mixing ratio, and the like of the porosity forming agent, the nucleating agent, and the solvent in the varnish are, for example, described in WO2018/186486.

A case where the resin is a polyimide resin is described. The precursor of the polyimide resin is, for example, a reaction product of a diamine component and an acid dianhydride component. Examples of the diamine component include aromatic diamines and aliphatic diamines. As the diamine component, from the viewpoint of obtaining the tensile elastic modulus of the above-described upper limit or less, preferably, an aromatic diamine is used.

Further, the diamine components and the acid dianhydride components each may be used alone or in combination. Specifically, as the diamine component, preferably, an aromatic diamine is used alone, preferably, an aromatic diamine and an aliphatic diamine are used in combination.

<Single Use of Aromatic Diamine>

An embodiment in which the aromatic diamine is used alone is described.

Examples of the aromatic diamine include first diamines, second diamines, and third diamines.

The first diamine includes a single aromatic ring. Examples of the first diamine include phenylenediamine, dimethylbenzenediamine, and ethylmethylbenzenediamine. From the viewpoint of mechanical strength, preferably, a phenylenediamine is used. Examples of the phenylenediamine include o-phenylenediamine, m-phenylenediamine, and p-phenylenediamine. As the phenylenediamine, preferably, a p-phenylenediamine is used. The p-phenylenediamine may be abbreviated as PDA.

The second diamine includes a plurality of aromatic rings and an ether bond disposed between them. An example of the second diamine includes an oxydianiline. Examples of the oxydianiline include 3,4'-oxydianiline and 4,4'-oxydianiline. From the viewpoint of mechanical strength, preferably, a 4,4'-oxydianiline (also known as 4,4'-diaminodiphenylether) is used. The 4,4'-oxydianiline may be abbreviated as ODA.

The third diamine includes a plurality of aromatic rings and an ester bond disposed between them. An example of the third diamine includes an aminophenylaminobenzoate, and from the viewpoint of obtaining the tensile elastic modulus of the above-described lower limit or more, preferably, a 4-aminophenyl-4-aminobenzoate is used. The 4-aminophenyl-4-aminobenzoate may be abbreviated as APAB.

In addition to the first diamine to the third diamine, examples of the aromatic diamine include 4,4'-methylenedianiline, 4,4'-dimethylenedianiline, 4,4'-trimethylenedianiline, and bis(4-aminophenyl)sulfone.

The above-described diamine components may be used alone or in combination. As the diamine component, preferably, a combination of a first diamine, a second diamine, and a third diamine is used. More preferably, a combination of a p-phenylenediamine (PDA), a 4,4'-oxydianiline (ODA), and a 4-aminophenyl-4-aminobenzoate (APAB) is used.

A mole fraction of the first diamine in the diamine component is, for example, 10 mol% or more, preferably 20 mol% or more, and for example, 70 mol% or less, preferably 65 mol% or less. A mole fraction of the second diamine in the diamine component is, for example, 5 mol% or more, preferably 10 mol% or more, and for example, 40 mol% or less, preferably 30 mol% or less. A mole fraction of the third diamine in the diamine component is, for example, 5 mol% or more, for example, 10 mol% or more, and for example, 40 mol% or less, preferably 30 mol% or less.

In addition, a part by mole of the third diamine with respect to 100 parts by mole of the total sum of the first diamine and the second diamine is, for example, 5 parts by mole or more, preferably 10 parts by mole or more, more preferably 20 parts by mole or more, and for example, 100 parts by mole or less, preferably 50 parts by mole or less, more preferably 30 parts by mole or less.

<Combined Use of Aromatic Diamine and Aliphatic Diamine>

An embodiment in which the aromatic diamine and the aliphatic diamine are used in combination is described. An example of the aromatic diamine includes the above-described aromatic diamine, and preferably, a first diamine is used, more preferably, a p-phenylenediamine (PDA) is used.

The aliphatic diamine may include a cyclic portion in a molecule, while including a long-chain alkyl group. Examples of the aliphatic diamine include hexamethylenediamine, 1,3-bis(aminomethyl)cyclohexane, and dimer diamine. As the aliphatic diamine, preferably, a dimer diamine is used. The dimer diamine is, for example, an amine compound in which two carboxyl groups possessed by a dimer acid are substituted with a primary amino group. The dimer acid is a dimer of an unsaturated fatty acid. An example of the unsaturated fatty acid includes an oleic acid. The dimer diamine is, for example, described in Japanese Unexamined Patent Publications No. 2020-172667, and 2018-168369. As the dimer diamine, a commercially available product may be used, and specifically, the PRIAMINE series (manufactured by Croda International Plc) is used.

In the embodiment in which the aromatic diamine and the aliphatic diamine are used in combination, a mole fraction of the aromatic diamine in the diamine component is preferably 40 mol% or more, more preferably 55 mol% or more, more preferably 70 mol% or more, and for example, 98 mol% or less, preferably 90 mol% or less, more preferably 85 mol% or less. A mole fraction of the aliphatic diamine in the diamine component is preferably 2 mol% or more, more preferably 10 mol% or more, more preferably 15 mol% or more, and for example, 60 mol% or less, preferably 45 mol% or less, more preferably 30 mol% or less. A part by mole of the aliphatic diamine with respect to 100 parts by mole of the aromatic diamine is, for example, 0.1 parts by mole or more, preferably 1 part by mole or more, more preferably 5 parts by mole or more, and for example, below 50 parts by mole, preferably 40 parts by mole or less, more preferably 30 parts by mole or less.

<Acid Dianhydride Component>

The acid dianhydride component is not limited. The acid dianhydride component contains, for example, an acid dianhydride including an aromatic ring. An example of the acid dianhydride including an aromatic ring includes an aromatic tetracarboxylic acid dianhydride. Examples of the aromatic tetracarboxylic acid dianhydride include benzenetetracarboxylic acid dianhydride, benzophenone tetracarboxylic acid dianhydride, biphenyltetracarboxylic acid dianhydride, biphenylsulfone tetracarboxylic acid dianhydride, and naphthalenetetracarboxylic acid dianhydride.

An example of the benzenetetracarboxylic acid dianhydride includes a benzene-1,2,4,5-tetracarboxylic acid dianhydride (also known as pyromellitic acid dianhydride). An example of the benzophenone tetracarboxylic acid dianhydride includes a 3,3'-4,4'-benzophenone tetracarboxylic acid dianhydride. Examples of the biphenyltetracarboxylic acid dianhydride include 3,3'-4,4'-biphenyltetracarboxylic acid dianhydride, 2,2'-3,3'-biphenyltetracarboxylic acid dianhydride, 2,3,3',4'-biphenyltetracarboxylic acid dianhydride, and 3,3',4,4'-diphenylethertetracarboxylic acid dianhydride. An example of the biphenylsulfone tetracarboxylic acid dianhydride includes a 3,3',4,4'-biphenylsulfone tetracarboxylic acid dianhydride. Examples of the naphthalenetetracarboxylic acid dianhydride include 2,3,6,7-naphthalenetetracarboxylic acid dianhydride, 1,2,5,6-naphthalenetetracarboxylic acid dianhydride, 1,2,4,5-naphthalenetetracarboxylic acid dianhydride, and 1,4,5,8-naphthalenetetracarboxylic acid dianhydride. These may be used alone or in combination. As the acid dianhydride component, from the viewpoint of mechanical strength, preferably, a biphenyltetracarboxylic acid dianhydride is used, more preferably, a 3,3'-4,4'-biphenyltetracarboxylic acid dianhydride is used. The 3,3'-4,4'-biphenyltetracarboxylic acid dianhydride may be abbreviated as BPDA.

A ratio of the diamine component to the acid dianhydride component is adjusted so that a mole amount of amino groups ($-NH_2$) of the diamine component and a mole amount of acid anhydride groups (-CO-O-CO-) of the acid dianhydride component are, for example, an equal amount.

To prepare the precursor of the polyimide resin, the above-described diamine component, the above-described acid dianhydride component, and a solvent are blended to prepare a varnish, and the varnish is heated to prepare a precursor solution. Subsequently, a nucleating agent and a porosity forming agent are blended into the precursor solution to prepare a porous precursor solution.

Thereafter, the porous precursor solution is applied to the other surface in the thickness direction of the metal layer 3 to form a coating film.

Thereafter, the coating film is dried by heating to form a precursor film. By the above-described heating, the precursor film having a phase separation structure of a polyimide resin precursor and the porosity forming agent with the nucleating agent as a core is prepared, while the removal of the solvent proceeds.

Thereafter, for example, the porosity forming agent is extracted (pulled out or removed) from the precursor film by a supercritical extraction method using supercritical carbon dioxide as a solvent.

Thereafter, the precursor film is cured by heating to form the porous resin layer 2 made of the polyimide resin.

Thereafter, if necessary, as shown by a solid line of FIG. 1, the metal layer 3 is removed. For example, the metal layer 3 is dissolved using a stripping solution. An example of the stripping solution includes $FeCl_3$. Thus, the film 1 for a metal layer laminate board including the porous resin layer 2 is obtained. When a metal layer laminate board 10 to be described later is produced, the above-described metal layer 3 is not removed, and left as the metal layer 3.

<Application>

Next, as shown by the phantom line of FIG. 1, the metal layer laminate board 10 including the film 1 for a metal layer laminate board is described. The metal layer laminate board 10 includes the film 1 for a metal layer laminate board including the porous resin layer 2 and the metal layer 3 shown by the phantom line.

The film 1 for a metal layer laminate board is provided in the metal layer laminate board 10. That is, the film 1 for a metal layer laminate board is used for lamination of the metal layer 3.

The metal layer 3 is disposed on the one surface 11 in the thickness direction of the porous resin layer 2. Specifically, the metal layer 3 in in contact with the one surface 11 in the thickness direction of the porous resin layer 2. Therefore, the metal layer laminate board 10 includes the porous resin layer 2 and the metal layer 3 in order toward one side in the thickness direction. As a material for the metal layer 3, a metal illustrated in the metal layer 3 is used. Preferably, copper is used. The metal layer 3 has a thickness of, for example, 0.1 $\mu$m or more, preferably 1 $\mu$m or more, and for example, 100 $\mu$m or less, preferably 50 $\mu$m or less.

In order to produce the metal layer laminate board 10, a laminate 21 which is in the middle of production of the film 1 for a metal layer laminate board and includes the metal layer 3 and the film 1 for a metal layer laminate board is subjected as it is as the metal layer laminate board 10. Thus, the metal layer laminate board 10 including the film 1 for a metal layer laminate board and the metal layer 3 disposed on the one surface 11 in the thickness direction thereof is produced. Thereafter, the metal layer 3 is, for example, formed into a pattern by etching and the like.

The metal layer laminate board 10 is pressed before, during and/or after the formation of the above-described pattern in accordance with its application and purpose. Specifically, the metal layer laminate board 10 is thermally pressed. Thus, the metal layer laminate board 10 is produced.

The metal layer laminate board 10 is, for example, used for wireless communication of the fifth generation (5G) standard, and a high-speed flexible printed board (FPC).

(Function and Effect of One Embodiment)

In the film 1 for a metal layer laminate board, since a tensile elastic modulus of the porous resin layer 2 is 800 MPa or more, it is possible to suppress a reduction rate of the thickness of the film 1 for a metal layer laminate board after pressing.

Further, in the film 1 for a metal layer laminate board, since the tensile elastic modulus of the porous resin layer 2 is 2000 MPa or less, it is possible to improve the stiffness of the film 1 for a metal layer laminate board.

Also, since the metal layer laminate board 10 includes the above-described film 1 for a metal layer laminate board, it has excellent stiffness, while capable of suppressing a reduction rate of the thickness after pressing.

(Modified Examples)

In each modified example below, the same reference numerals are provided for members and steps corresponding to each of those in the above-described one embodiment, and their detailed description is omitted. Each modified example can achieve the same function and effect as that of one embodiment unless otherwise specified. Furthermore, one embodiment and the modified example thereof can be appropriately used in combination.

As shown in FIG 2, the metal layer laminate board 10 may further include a second metal layer 4. The metal layer laminate board 10 includes the metal layer 4, the porous resin layer 2, and the metal layer 3 in order toward one side in the thickness direction. A configuration of the second metal layer 4 is the same as that of the metal layer 3.

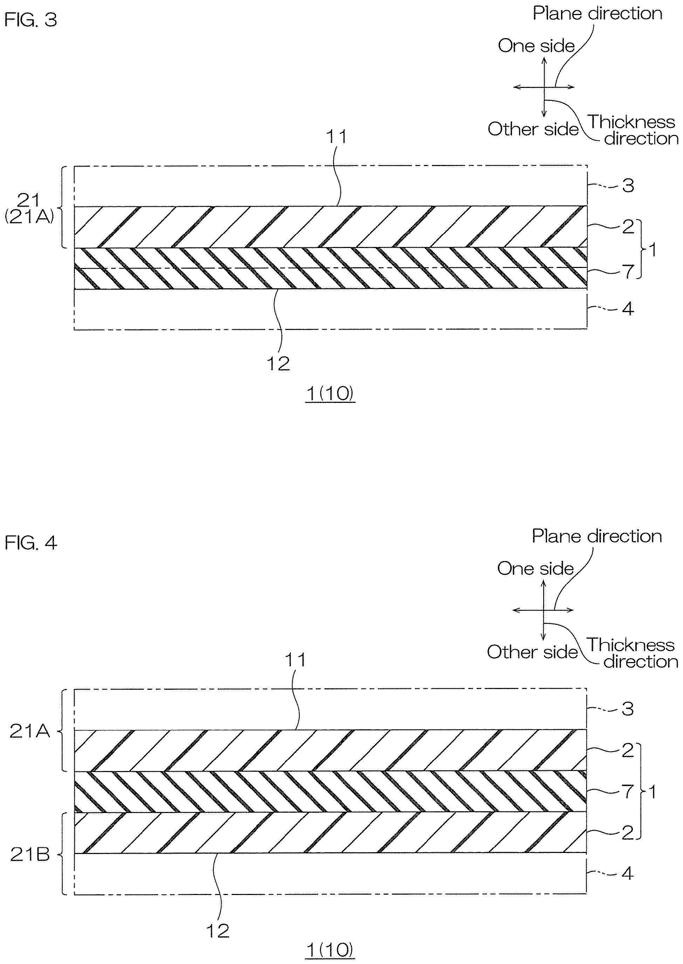

As shown in FIG. 3, each of the film 1 for a metal layer laminate board and the metal layer laminate board 10 may further include an adhesive layer 7. The film 1 for a metal layer laminate board shown by the solid line of FIG. 3 includes the adhesive layer 7 and the porous resin layer 2 in order toward one side in the thickness direction. The metal layer laminate board 10 shown by the solid line and the phantom line of FIG. 3 includes the second metal layer 4 (phantom line), the adhesive layer 7, the porous resin layer 2, and the metal layer 3 in order toward one side in the thickness direction. Since the adhesive layer 7 is disposed between the two layers of the porous resin layer 2 and the second metal layer 4, it may be referred to as an "interlayer adhesive layer".

The adhesive layer 7 is disposed on the other surface in the thickness direction of the porous resin layer 2. Specifically, the adhesive layer 7 is in contact with the other surface in the thickness direction of the porous resin layer 2. The adhesive layer 7 forms the other surface 12 of the film 1 for a metal layer laminate board. Further, the adhesive layer 7 may be any of a single layer or multiple layers (specifically, two layers). A thickness of the adhesive layer 7 is not limited. The adhesive layer 7 has a thickness of, for example, 1 μm or more, preferably 5 μm or more, and for example, 50 μm or less, preferably 30 μm or less. A material for the adhesive layer 7 is not limited. An example of the material for the adhesive layer 7 includes an adhesive composition, and preferably, a curable adhesive composition is used, more preferably, a thermosetting adhesive composition is used, further more preferably, an epoxy-based thermosetting adhesive composition is used.

In order to produce the metal layer laminate board 10 and the film 1 for a metal layer laminate board shown in FIG. 3, the laminate 21 shown in FIG. 1 (the metal layer laminate board 10) and an adhesive laminate 20 are prepared. The adhesive laminate 20 includes the second metal layer 4 and the adhesive layer 7 in order toward one side in the thickness direction. Next, the adhesive layer 7 of the adhesive laminate 20 is bonded to the porous resin layer 2 of the laminate 21 shown in FIG. 1. When a material for the adhesive layer 7 is a thermosetting adhesive composition, then, the adhesive layer 7 is completely cured by heating. Thus, the metal layer laminate board 10 including the second metal layer 4, the adhesive layer 7, the porous resin layer 2, and the metal layer 3 in order toward one side in the thickness direction is obtained.

Subsequently, the second metal layer 4 and the metal layer 3 are removed. Thus, the film 1 for a metal layer laminate board including the adhesive layer 7 and the porous resin layer 2 in order toward one side in the thickness direction is obtained.

As shown by the solid line of FIG. 4, the film 1 for a metal layer laminate board may include the two porous resin layers 2. The film 1 for a metal layer laminate board includes the two porous resin layers 2, and the adhesive layer 7 sandwiched between the two porous resin layers 2 in the thickness direction. Specifically, the film 1 for a metal layer laminate board includes the porous resin layer 2, the adhesive layer 7, and the porous resin layer 2 in order toward one side in the thickness direction. The metal layer laminate board 10 shown by the solid line and the phantom line in FIG. 4 includes the film 1 for a metal layer laminate board, the metal layer 3, and the second metal layer 4 described above. Specifically, the metal layer laminate board 10 includes the second metal layer 4, the porous resin layer 2, the adhesive layer 7, the porous resin layer 2, and the metal layer 3 in order toward one side in the thickness direction. In order to produce the metal layer laminate board 10 shown in FIG. 4, the porous resin layer 2 of a first laminate 21A including the metal layer 3 and the porous resin layer 2 is bonded to the porous resin layer 2 of a second laminate 21B including the second metal layer 4 and the porous resin layer 2 via the adhesive layer 7.

Examples

Next, the present invention is further described based on Examples and Comparative Examples below. The present invention is however not limited by these Examples and Comparative Examples. The specific numerical values in mixing ratio (content ratio), property value, and parameter used in the following description can be replaced with upper limit values (numerical values defined as "or less" or "below") or lower limit values (numerical values defined as "or more" or "above") of corresponding numerical values in mixing ratio (content ratio), property value, and parameter described in the above-described "DESCRIPTION OF

EMBODIMENTS".

<Example 1>

<Example Corresponding to FIG. 1>

A p-phenylenediamine (PDA) (first diamine) (64.88 g (0.60 mol)), 40.05 g (0.20 mol) of a 4,4'-oxydianiline (ODA) (second diamine), and 45.65 g (0.20 mol) of a 4-aminophenyl-4-aminobenzoate (APAB) (third diamine) were dissolved with 2300 g of an N-methyl-2-pyrrolidone (NMP) to prepare a diamine component solution. Subsequently, 294.2 g (1.00 mol) of a 3,3'-4,4'-biphenyltetracarboxylic acid dianhydride (BPDA) was added to the prepared diamine component solution, and the resulting mixture was stirred at 80°C. The stirring was stopped and cooled to prepare a polyimide precursor solution.

As a porosity forming agent, 150 parts by mass of a polyoxyethylene dimethyl ether having a weight average molecular weight of 400 (manufactured by NOF CORPORATION, grade: MM400), and as a nucleating agent, 3 parts by mass of a PTFE powder having a particle size of 1 $\mu$m or less were added to 100 parts by mass of the polyimide precursor solution to be stirred, thereby obtaining a transparent uniform solution. As an imidization catalyst, 4 parts by mass of a 2-methylimidazole was added to the obtained solution, thereby preparing a varnish.

The prepared varnish was applied to the metal layer 3 made of a copper foil (manufactured by FUKUDA METAL FOIL & POWDER CO., LTD., CF-T49A-DS-HD2) to be heated and dried, thereby removing NMP. Thus, the polyimide precursor film having a thickness of about 50 $\mu$m was fabricated on one surface in the thickness direction of the metal layer 3.

Thereafter, by immersing the polyimide precursor film and the metal layer 3 into supercritical carbon dioxide pressurized to 30 MPa at 60°C and by circulating the above-described supercritical carbon dioxide for five hours, extraction removal of the porosity forming agent, phase separation of the remaining NMP, and formation of pores were promoted. Thereafter, the supercritical carbon dioxide was reduced in pressure, thereby obtaining a polyimide precursor porous film including the metal layer 3.

Furthermore, the obtained polyimide precursor porous film including the metal layer 3 was heated under vacuum at 390°C for 185 minutes to promote removal and imidization of the remaining component, thereby producing the metal layer laminate board 10 including the second metal layer 4 and the porous resin layer 2 (copper-coated laminate board including copper foil on one surface) (CCL).

Thereafter, the metal layer laminate board 10 was immersed in a $FeCl_3$ solution, and the metal layer 3 was dissolved and removed. Thus, the film 1 for a metal layer laminate board including the porous resin layer 2 was produced.

<Example 2>

<Example Corresponding to FIG. 3>

The first laminate 21A including the metal layer 3 and the porous resin layer 2 in Example 1, the adhesive layer 7 made of the epoxy-based adhesive composition (uncured) having a thickness of 10 $\mu$m, and the metal layer 4 were pressed using a pressing machine under vacuum at 60°C at 1 MPa for 10 seconds. At that time, the adhesive layer 7 was sandwiched between the porous resin layer 2 and the metal layer 4. Thereafter, the adhesive layer 7 was completely cured by further heating and pressing under vacuum at 160°C at 3 MPa for 30 minutes. Thus, as shown in FIG. 3, the porous resin layer 2 was bonded to the metal layer 4 by the adhesive layer 7. Thus, the metal layer laminate board 10 including the second metal layer 4, the adhesive layer 7, the porous resin layer 2, and the metal layer 3 in order toward one side in the thickness direction was produced.

Thereafter, the metal layer laminate board 10 was immersed in a $FeCl_3$ solution, and the metal layer 3 and the second metal layer 4 were dissolved and removed. Thus, the film 1 for a metal layer laminate board including the adhesive layer 7 and the porous resin layer 2 was produced.

<Example 3>

<Example Corresponding to FIG. 4>

The adhesive layer 7 made of the epoxy-based adhesive composition (uncured) having a thickness of 10 $\mu$m was sandwiched between the two laminates 21 (the first laminate 21A and the second laminate 21B) in Example 1, and the resulting product was pressed using a pressing machine under vacuum at 60°C at 1 MPa for 10 seconds. At that time, the adhesive layer 7 was sandwiched between the two porous resin layers 2. Thereafter, the adhesive layer 7 was completely cured by further heating and pressing under vacuum at 160°C at 3 MPa for 30 minutes. Thus, as shown in FIG. 4, the metal layer laminate board 10 including the second metal layer 4, the porous resin layer 2, the adhesive layer 7, the porous resin layer 2, and the metal layer 3 in order toward one side in the thickness direction was produced.

Thereafter, the metal layer laminate board 10 was immersed in a $FeCl_3$ solution, and the metal layer 3 and the second metal layer 4 were dissolved and removed. Thus, the film 1 for a metal layer laminate board including the porous resin layer 2, the adhesive layer 7, and the porous resin layer 2 was produced.

<Example 4>

<Example Corresponding to FIG. 3>

The film 1 for a metal layer laminate board was produced in the same manner as in Example 2. However, the two layers of the adhesive layers 7 were used in lamination.

<Example 5>

<Example Corresponding to FIG. 1 with Diamine Component Containing Aromatic Diamine and Aliphatic Diamine>

A 99.49 g (0.92 mol) of p-phenylenediamine (PDA) (aromatic diamine: first diamine) and 42.8 g (0.08 mol) of PRIAMINE 1075 (manufactured by Croda International Plc) (aliphatic diamine: dimer diamine) were dissolved with 2258 g of an N-methyl-2-pyrrolidone (NMP) to prepare a diamine component solution. Subsequently, 294.22 g (1.00 mol) of a 3,3'-4,4'-biphenyltetracarboxylic acid dianhydride (BPDA) was added to the prepared diamine component solution, and the resulting mixture was stirred at 80°C. The stirring was stopped and cooled to prepare a polyimide precursor solution.

As a porosity forming agent, 200 parts by mass of a polyoxyethylene dimethyl ether having a weight average molecular weight of 400 (manufactured by NOF CORPORATION, grade: MM400), and as a nucleating agent, 3 parts by mass of a PTFE powder having a particle size of 1 $\mu$m or less were added to 100 parts by mass of the polyimide precursor solution to be stirred, thereby obtaining a transparent uniform solution. As an imidization catalyst, 4 parts by mass of a 2-methylimidazole was added to the obtained solution, thereby preparing a varnish. The prepared varnish was applied to the metal layer 3 made of a copper foil (manufactured by FUKUDA METAL FOIL & POWDER CO., LTD., CF-T49A-DS-HD2) to be heated and dried, thereby removing NMP. Thus, the polyimide precursor film having a thickness of about 25 $\mu$m was fabricated on one surface in the thickness direction of the metal layer 3.

Thereafter, by immersing the polyimide precursor film and the metal layer 3 into supercritical carbon dioxide pressurized to 30 MPa at 60°C and by circulating the above-described supercritical carbon dioxide for five hours, extraction removal of the porosity forming agent, phase separation of the remaining NMP, and formation of pores were promoted. Thereafter, the supercritical carbon dioxide was reduced in pressure, thereby obtaining a polyimide precursor porous film including the metal layer 3.

Furthermore, the obtained polyimide precursor porous film including the metal layer 3 was heated under vacuum at 350°C for 185 minutes to promote removal and imidization of the remaining component, thereby producing the metal layer laminate board 10 including the second metal layer 4 and the porous resin layer 2 (copper-coated laminate board including copper foil on one surface) (CCL).

Thereafter, the metal layer laminate board 10 was immersed in a $FeCl_3$ solution, and the metal layer 3 was dissolved and removed. Thus, the film 1 for a metal layer laminate board including the porous resin layer 2 was produced.

<Comparative Example 1>

The film 1 for a metal layer laminate board was produced in the same manner as in Example 1. However, as the varnish of the polyimide precursor, the varnish prepared in conformity with Example 1 of WO2018/186486 was used. Specifically, a diamine component containing PDA and ODA was used.

<Comparative Example 2>

The film 1 for a metal layer laminate board was produced in the same manner as in Example 3. However, as the varnish of the polyimide precursor, the varnish prepared in conformity with Example 1 of WO2018/186486 was used. Specifically, a diamine component containing PDA and ODA was used.

<Evaluation>

The following properties were evaluated for each of the films 1 for a metal layer laminate board and the porous resin layers 2 of Examples 1 to 5 and Comparative Examples 1 to 2. The results are shown in Table 1.

<<Properties of Porous Resin Layer 2>>

<Porosity>

A porosity of the porous resin layer 2 was determined by calculation based on the following formula.

$$\text{Dielectric constant of the porous resin layer 2= dielectric constant of air} \times \text{porosity+}$$

$$\text{dielectric constant of non-porous polyimide} \times (1\text{- porosity})$$

Since the dielectric constant of the air is 1, and the dielectric constant of the non-porous polyimide is 3.5:

$$\text{Dielectric constant of the porous resin layer 2= porosity+ 3.5 (1- porosity)}$$

$$\text{Porosity= (3.5- dielectric constant of the porous resin layer 2)/ 2.5}$$

$$\text{Porosity (\%)= [(3.5- dielectric constant of the porous resin layer 2)/ 2.5]} \times 100$$

A dielectric constant of the porous resin layer 2 was measured at a frequency of 10 GHz by a dielectric resonant method.

<Tensile Elastic Modulus>

The porous resin layer 2 was trimmed into a size having a width of 5 mm and a length of 100 mm, thereby fabricating a sample. The fabricated sample was subjected to a tensile test with a distance between chucks of 40 mm at a rate of 5 mm/min using a tensile testing machine (manufactured by MinebeaMitsumi Inc., TG-1kN). The tensile test was carried out at 25°C. A stress-strain curve was obtained by the tensile test. The tensile elastic modulus was obtained as an initial inclination in the stress-strain curve.

<<Properties of Film 1 for Metal Layer Laminate Board>>

<Thickness>

A thickness of the film 1 for a metal layer laminate board was measured using a thickness meter (manufactured by Fujiwork Co., Ltd.).

<Dielectric Constant>

A dielectric constant at 10 GHz of the film 1 for a metal layer laminate board was measured by a resonant method.

<Tensile Elastic Modulus>

A tensile elastic modulus at 25°C of the film 1 for a metal layer laminate board was measured. The tensile elastic modulus of the film 1 for a metal layer laminate board was measured in the same manner as the method for measuring the tensile elastic modulus of the porous resin layer 2.

<Stiffness (Bias Force Method)>

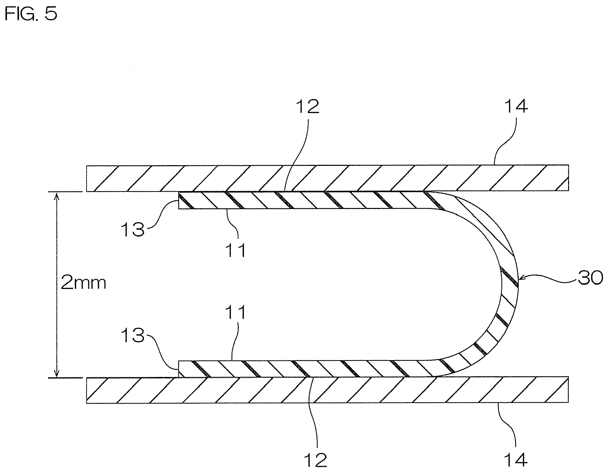

The film 1 for a metal layer laminate board was trimmed into a size having a length of 30 mm and a width of 10 mm to fabricate a sample 30. As shown in FIG. 5, the sample 30 was bent so that both end portions 13 in a longitudinal direction of the sample 30 were brought closer to each other, the one surfaces 11 in the thickness direction of both end portions 13 faced each other, and a distance between the other surfaces 12 in the thickness direction of both end portions 13 was 2 mm. When the sample 30 was bent, each of two plates 14 was brought into contact with each of both end portions of the other surface 12 in the thickness direction. The two plates are in parallel. A force in an opposing direction of the bent sample 30 was measured. Stiffness was determined based on the following formula. A unit of the stiffness was mN/mm. The above-described measurement method is referred to as a bias force method.

$$\text{(Force at the time of bending- initial mass)/ 10 mm in width}$$

<Reduction Rate of Thickness after Pressing>

A sample having a size of 40 mm× 40 mm was fabricated from the film 1 for a metal layer laminate board. The sample was set in an instantaneous vacuum lamination device VS008-1515 (manufactured by MIKADO TECHNOS CO., LTD.) and pressed at 160°C at a pressure of 5 MPa for 300 seconds. A reduction rate of the thickness after pressing was determined based on the following formula.

$$\text{Reduction rate of thickness after pressing (\%)} = \text{(thickness before pressing- thickness after pressing)/ thickness before pressing} \times 100$$

Then, regarding the reduction rate of the thickness after pressing, thermal pressing properties were evaluated based on the following criteria.

Bad: reduction rate of the thickness after pressing was above 5%.
Good: reduction rate of the thickness after pressing was 5% or less.

[Table 1]

| Table 1 | | Ex. 1 | Ex. 2 | Ex. 3 | Ex. 4 | Ex. 5 | Comparative Ex. 1 | Comparative Ex. 2 |
|---|---|---|---|---|---|---|---|---|
| Diamine Component | | PDA, ODA, and APAB | | | | PDA and PRIAMINE 1075 | PDA and ODA | |
| Porous Resin Layer | Porosity (%) | 80 | 80 | 80 | 80 | 60 | 81 | 81 |
| | Tensile Elastic Modulus (Mpa) | 1001 | 1001 | 1001 | 1001 | 1699 | 755 | 755 |
| Film for Metal Layer Laminate Board | Thickness ($\mu$m) | 60 | 60 | 110 | 80 | 25 | 50 | 120 |
| | Dielectric Constant | 1.54 | 1.88 | 1.74 | 1.87 | 2.00 | 1.58 | 1.79 |
| | Tensile Elastic Modulus (Mpa) | 1001 | 822 | 853 | 758 | 1699 | 755 | 423 |
| | Stiffness (Bias Force Method) (mN/mm) | 3.8 | 4.0 | 13.1 | 5.3 | 1.9 | 4.1 | 16.5 |
| | Press Resistance (Reduction Rate of Thickness after Thermal Pressing) | Good | Good | Good | Good | Good | Bad | Bad |
| Correspondance FIG. | | FIG. 1 | FIG. 3 | FIG. 4 | FIG. 3 | FIG. 1 | FIG. 1 | FIG. 4 |

While the illustrative embodiments of the present invention are provided in the above description, such is for illustrative purpose only and it is not to be construed as limiting the scope of the present invention. Modification and variaton of the present invention that will be obvious to those skilled in the art is to be covered by the following claims.

Description of Reference Numerals

1     Film for metal layer laminate board
2     Porous resin layer
3     Metal layer
4     Second metal layer
7     Adhesive layer
10    Metal layer laminate board
11    One surface

**Claims**

1. A film for a metal layer laminate board comprising:
   a porous resin layer having a tensile elastic modulus at 25°C of 800 MPa or more and 2000 MPa or less.

2. The film for a metal layer laminate board according to claim 1 further comprising:
   an adhesive layer disposed on one surface in a thickness direction of the porous resin layer.

3. A metal layer laminate board comprising:

   the film for a metal layer laminate board according to claim 1 or 2, and
   a metal layer disposed on one surface in a thickness direction of the film for a metal layer laminate board.

FIG. 1

Plane direction
One side
Other side Thickness direction

11
21
12
3
2
1(10)

FIG. 2

Plane direction
One side
Other side Thickness direction

11
1
12
3
2
4
10

FIG. 3

Plane direction

One side

Other side — Thickness direction

1(10)

FIG. 4

Plane direction

One side

Other side — Thickness direction

1(10)

FIG. 5

**EP 4 079 510 A1**

Europäisches Patentamt
European Patent Office
Office européen des brevets

# EUROPEAN SEARCH REPORT

Application Number

EP 22 16 8563

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2009/197068 A1 (YAMAGUCHI HIROAKI [JP] ET AL) 6 August 2009 (2009-08-06) * paragraph [0028] – paragraph [0029] * * paragraph [0055] – paragraph [0058] * * paragraph [0079] – paragraph [0084] * * paragraph [0106] * * claims 7,8 * * tables 1-1;1-2 * | 1-3 | INV. B32B5/20 B32B7/12 B32B15/04 B32B15/20 C08G73/10 H05K1/03 |
| X | JP 2020 076072 A (UNITIKA LTD) 21 May 2020 (2020-05-21) * paragraph [0020] – paragraph [0022] * * paragraph [0028] * * example 1 * * claims 1-3 * | 1-3 | |
| | | | TECHNICAL FIELDS SEARCHED (IPC) |
| | | | B32B C08G C08J C09J H05K |

The present search report has been drawn up for all claims

| Place of search | Date of completion of the search | Examiner |
|---|---|---|
| The Hague | 6 September 2022 | Sanchez Perucha, A |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

17

## ANNEX TO THE EUROPEAN SEARCH REPORT
## ON EUROPEAN PATENT APPLICATION NO.

EP 22 16 8563

This annex lists the patent family members relating to the patent documents cited in the above-mentioned European search report.
The members are as contained in the European Patent Office EDP file on
The European Patent Office is in no way liable for these particulars which are merely given for the purpose of information.

06-09-2022

| Patent document cited in search report | | Publication date | Patent family member(s) | | Publication date |
|---|---|---|---|---|---|
| US 2009197068 | A1 | 06-08-2009 | CN | 101497694 A | 05-08-2009 |
| | | | JP | 5233298 B2 | 10-07-2013 |
| | | | JP | 2009185101 A | 20-08-2009 |
| | | | KR | 20090084772 A | 05-08-2009 |
| | | | TW | 200938568 A | 16-09-2009 |
| | | | US | 2009197068 A1 | 06-08-2009 |
| JP 2020076072 | A | 21-05-2020 | JP | 7095880 B2 | 05-07-2022 |
| | | | JP | 2020076072 A | 21-05-2020 |
| | | | TW | 202027985 A | 01-08-2020 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2018186486 A

- JP 2020172667 A
- JP 2018168369 A